# EUROPÄISCHE PATENTANMELDUNG

(11) **EP 1 251 190 A1**
(43) Veröffentlichungstag der Anmeldung: **23.10.2002**
(21) Anmeldenummer: 02002925.2
(22) Anmeldetag: 09.02.2002
(51) Int. Cl.: C23C 16/04

(54) **Verfahren zum gleichmässigen Beschichten von Hohlkörpern**

(30) Priorität: 21.04.2001 DE 10119571
(71) Anmelder: Schott Glas, 55122 Mainz (DE); CARL-ZEISS-STIFTUNG trading as Schott Glas, 55122 Mainz (DE)
(72) Erfinder: Meyer, Rolf, 37581 Bad Gandersheim (DE); Fischer, Dieter, 37581 Bad Gandersheim (DE); Zogg, Lutz, 37581 Bad Gandersheim (DE)

(57) **Zusammenfassung**

Die vorliegende Erfindung betrifft ein Verfahren zum gleichmäßigen Beschichten von Hohlkörpern, wobei das eine offene Ende des Hohlkörpers mit einem Deckel gasdicht verschlossen wird, der Hohlkörper in einen Plasma induzierten CVD Reaktor eingesetzt wird, an den Hohlkörper Vakuum angelegt wird, eine Beschichtungstemperatur eingestellt wird und die Plasma induzierte Beschichtung erfolgt. Die vorliegende Erfindung betrifft weiter die Verwendung des erfindungsgemäßen Verfahrens zum gleichmäßigen Beschichten von Hohlkörpern für die Beschichtung von Rohren, Behältern, Spritzenkörpern, Reflektoren, Kalotten und Trichtern.

## Beschreibung

Bei vielen Beschichtungsverfahren muss eine erhöhte Temperatur verwendet und ein Vakuum angelegt werden. Neue Beschichtungsverfahren, wie das Plasma induzierte CVD Verfahren, haben sich sehr gut insbesondere zur Beschichtung von Gläsern und Kunststoffen bewährt. Dazu wird ein gläserner Hohlkörper, wie eine Kalotte in einen Reaktor gegeben. Im Innenbereich des Hohlkörpers wird ein Vakuum von etwa 10⁻⁹ bar erzeugt. Um das Vakuum zu erzeugen muss das eine Ende der Kalotte verschlossen sein. Üblicherweise bleibt das Ende der Kalotte, wo der Brenner später eingesetzt wird, daher am Hals, durch einen Glasboden verschlossen. Es wird eine Temperatur von etwa 180° C im Innenraum der Kalotte erzeugt. Im Reaktor wird im Mikrowellenbereich ein Feld angelegt und gleichzeitig in den Innenraum der Kalotte ein Vorläufergas wie Hexamethyldisiloxan und Sauerstoff eingeleitet. Durch dieses Verfahren wird im Innenraum der Kalotte auf der Innenfläche eine SiO₂-Schicht aufgebracht. Die beschichteten Kalotten wird anschließend bis zum Erreichen einer eingestellten erhöhten Temperatur getempert.

Das beschriebene Verfahren eignet sich zum Beschichten von allen möglichen Hohlkörpern, wie Rohre, Reflektoren, Flaschen, Ampullen, Spritzenkörper, und Behälter. Die Hohlkörper können mit unterschiedlichen Schichten belegt werden. Bevorzugt werden die Flächen mit fast allen Metalloxiden, wie SiO₂, TiO₂, SnO₂, Al₂O₃ und ähnlichen Oxide beschichtet.

Bei den beschriebenen Beschichtungsverfahren, muss zum Anlegen eines Vakuums mindestens ein Ende verschlossen sein. Lecks würden die Haltbarkeit der Schichten verschlechtern. Wird das eine Ende durch einen Glasboden verschlossen, bildet sich eine sehr große Glasmenge an einer kleinen Stelle aus. Beim Aufheizen des Hohlkörpers wird der Glasboden schneller erwärmt. Um an jeder Stelle der zu beschichtenden Fläche eine erforderliche Arbeitstemperatur zu erreichen, muss der Hohlkörper länger aufgeheizt werden.

Bei einem verschlossenen Hohlkörper ist die Reinigung vor der Beschichtung sehr schwierig und unvollständig. Die vorherige Reinigung der Fläche ist unerlässlich, da für die Beschichtung ein glattes Substrat erforderlich ist. Ein weiterer Nachteil des herkömmlichen Verfahrens ist die nach erfolgter Beschichtung notwendige Abtrennung des Glasbodens mittels Sägen und anschließender Reinigung der Fläche. Selbst Öffnungen können erst nach der Beschichtung eingebracht werden.

Aufgabe der vorliegenden Erfindung ist ein wirtschaftliches und umweltfreundliches Verfahren zum gleichmäßigen Beschichten von Hohlkörpern bereitzustellen.

Die Aufgabe der vorliegenden Erfindung wird durch ein Verfahren zum gleichmäßigen Beschichten von Hohlkörpern gelöst, wobei das eine offene Ende des Hohlkörpers mit einem Deckel gasdicht verschlossen wird, der Hohlkörper in einen Plasma induzierten CVD Reaktor eingesetzt wird, an den Hohlkörper Vakuum angelegt wird, eine Beschichtungstemperatur eingestellt wird und die Plama induzierte Beschichtung erfolgt.

Mit der Deckel zum Abdichten des Hohlkörpers und des Glassubstrats werden wesentliche Vorteile erreicht. Das Glassubstrat ist zum Zeitpunkt der Beschichtung vakuumdicht. Das Glassubstrat lässt sich für das Beschichten gleichmäßig aufheizen und hat somit eine homogene Temperaturverteilung. Die Verarbeitungszeit und die Herstellungskosten werden verringert. Der Hohlkörper lässt sich vor der Beschichtung leicht reinigen, da er zwei Öffnungen hat. Dies bewirkt eine bessere Uniformität der Beschichtung, eine geringere Streuung der Uniformität sowie eine höhere Schichthaftung.

Eine bevorzugte Ausgestaltung der Erfindung besteht darin, dass der Deckel aus mindestens einem Kunststoff besteht. Mit einem solchen Deckel werden gute Ergebnisse bei der Beschichtung erreicht.

Eine besonders bevorzugte Ausgestaltung der Erfindung besteht darin, dass der Deckel mindestens einen Silikonkunststoff enthält. Mit einer solchen Silikonhaube werden besonders gute Ergebnisse bei der Beschichtung erreicht.

Erfindungsgemäß ist die Verwendung des Verfahrens für die Beschichtung von Rohren, Behältern, Spritzenkörpern, Reflektoren, Kalotten und Trichtern vorgesehen.

Die Erfindung wird anhand einer Zeichnung und von Beispielen näher erläutert.

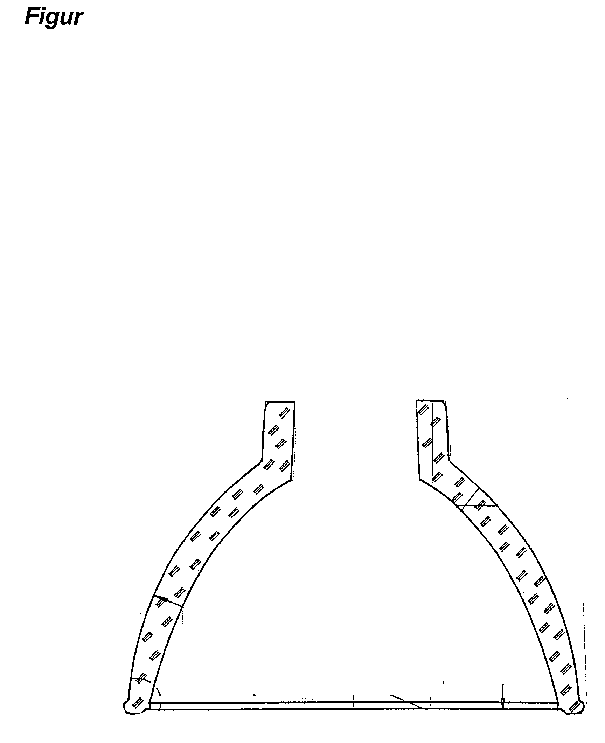

Die Zeichnung besteht aus einer Figur. Die Figur zeigt den Längsschnitt durch eine Kalotte, wobei der Glasboden am Hals abgeschnitten ist.

### Beispiel

Bei einer üblichen Kalotte mit einem Durchmesser von 5.5 cm an der Außenseite wurde der Glasboden abgesägt. Die an beiden Enden offene Kalotte wurde ausgewaschen und getrocknet. Das eine offene Enden wurde mit einem Silikonstopfen gasfest verschlossen. Die Kalotte wurde mit dem offenen Ende nach unten in einen Plasma induzierten CVD-Reaktor eingesetzt. Im Reaktor wurde ein Vakuum von 0.7 * 10⁻⁹ bar angelegt. Es wurde eine Temperatur von 180 °C eingestellt. Dann wurden abwechselnd Schichten aus SiO₂ ausgehend von Hexamethyldisiloxan in Verbindung mit Sauerstoff und Schichten aus TiO₂ aufgetragen. Es wurden insgesamt 33 Schichten aufgetragen. Zunächst wurde eine dünne SiO₂-Schicht und zum Schluss eine dicke SiO₂ aufgetragen. Dazwischen erfolgte die Beschichtung wechselweise. Die Gesamtzeit der Beschichtung betrug 6 Minuten. Es wurde eine homogene Schichtverteilung zwischen Hals und Flansch der Kalotte erreicht. Eine gleichmäßige Schichtverteilung wurde beobachtet.

### Vergleichsbeispiel

Das Verfahren wurde wie im Beispiel mit dem Unterschied durchgeführt, dass der Glasboden nicht abgesägt wurde. Die verschlossene Kalotte wurde sehr aufwendig ausgewaschen und getrocknet. Die Kalotte wurde in einen Plasma induzierten CVD-Reaktor eingesetzt. Im Reaktor wurde ein Vakuum von 0.7 * 10⁻⁹ bar angelegt. Eine Temperatur von 180 °C wurde eingestellt. Dann wurden abwechselnd Schichten aus SiO₂ aus Hexamethyldisiloxan in Verbindung mit Sauerstoff und Schichten aus TiO₂ aufgetragen. Es wurden insgesamt 33 Schichten aufgetragen. Zunächst wurde eine dünne SiO₂-Schicht und zum Schluss eine dicke SiO₂-Schicht aufgetragen. Dazwischen erfolgte die Beschichtung wechselweise. Die Gesamtzeit der Beschichtung betrug 7 Minuten. Es wurde eine inhomogene Schichtverteilung zwischen Hals und Flansch der Kalotte erreicht. Die Schicht war am Hals dünner als am Flansch. Das hängt mit der inhomogenen Temperaturverteilung zusammen. Eine ungleichmäßige Schichtverteilung wurde beobachtet. Anschließend musste der Glasboden vorsichtig und aufwendig mittels Sägen abgetrennt und die Kalotte musste erneut gereinigt werden.

## Patentansprüche

1. Verfahren zum gleichmäßigen Beschichten von Hohlkörpern, wobei
a) das eine offene Ende des Hohlkörpers mit einem Deckel gasdicht verschlossen wird,
b) der Hohlkörper in einen Plasma induzierten CVD Reaktor eingesetzt wird,
c) an den Hohlkörper Vakuum angelegt wird, eine Beschichtungstemperatur eingestellt wird und die Plasma induzierte Beschichtung erfolgt.

2. Verfahren nach Anspruch 1, wobei der Deckel aus mindestens einem Kunststoff besteht.

3. Verfahren nach Anspruch 1 oder 2, wobei der Deckel mindestens einen Silikonkunststoff enthält.

4. Verwendung eines Verfahren zum gleichmäßigen Beschichten von Hohlkörpern nach einem oder mehreren der Ansprüche 1 bis 3 für die Beschichtung von Rohren, Behältern, Spritzenkörpern, Reflektoren, Kalotten und Trichtern.
